# EUROPEAN PATENT SPECIFICATION

(11) **EP 0 641 024 B1**
(45) Date of publication and mention of the grant of the patent: **15.04.1998**
(21) Application number: 94306187.9
(22) Date of filing: 22.08.1994
(51) Int. Cl.: H01L 27/02

(54) **Semiconductor power device**
Leistungshalbleiterbauelement
Dispositif semi-conducteur de puissance

(30) Priority: 23.08.1993 JP 206772/93
(43) Date of publication of application: 01.03.1995
(73) Proprietor: FUJI ELECTRIC CO. LTD., Kawasaki 210 (JP)
(72) Inventor: Furuhata, Shoichi, c/o Fuji Electric Co. Ltd., Kawasaki-ku, Kawasaki 210 (JP)
(74) Representative: Bridge-Butler, Alan James

(56) References cited:
- EP-A- 0 224 274
- DE-A- 4 109 183
- GB-A- 2 210 501
- GB-A- 2 261 321
- PATENT ABSTRACTS OF JAPAN vol. 13, no. 246 (E-769) (3594) 8 June 1989 & JP-A-01 047 077 (TDK CORP) 21 February 1989

## Description

The present invention concerns semiconductor devices, and more specifically relates to a configuration and peripheral structure of a temperature monitoring element for monitoring the temperature of a power IC device.

Nowadays, a power MOSFET that is easily driven is widely used for controlling electric power. As a result of the progress and improvement in manufacturing process technology, power IC devices which mount the power MOSFET on a chip together with a control circuit for controlling the power MOSFET have been put into the market. Because a power block and the control circuit adjoin each other in the power IC device, a protective circuit for protecting the control circuit against excessive temperature rises of the power block should be provided since an excessive temperature rise can cause malfunction and breakdown of the control circuit. To achieve such protection, a temperature monitoring element that feeds temperature information of the power block to the protective circuit is mounted as a temperature sensor on the chip.

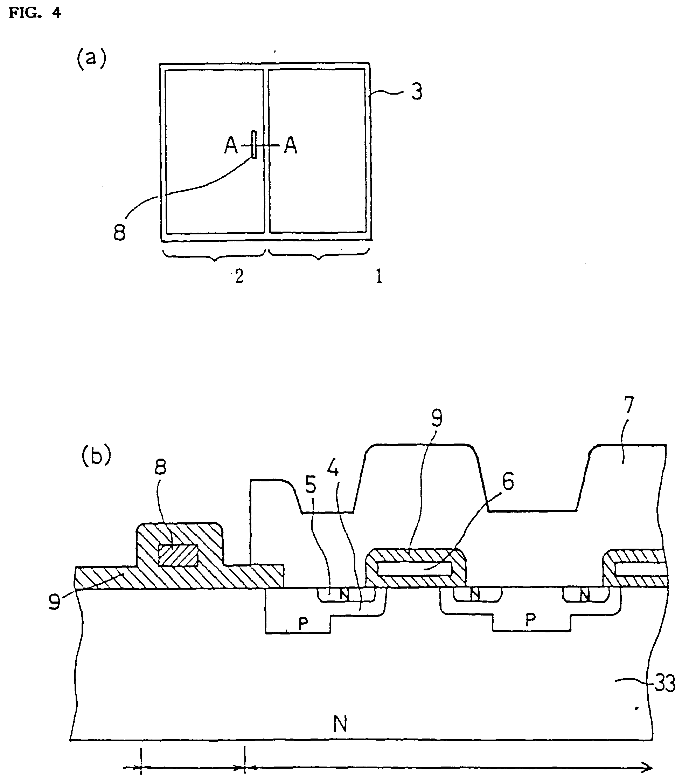

Figures 4a and 4b explain a configuration and peripheral structure of a temperature monitoring element in the power IC device according to the prior art, as seen in EP-A-224 274 (corresponding to the preamble of claim 1).

Figure 4a is a top plan view showing an entire planar chip configuration of the power IC device. In Figure 4a, a temperature monitoring element 8 is arranged in a control circuit block 2 adjacent a boundary between a power block (power MOSFET block) 1 and the control circuit block (IC block) 2.

Figure 4b is a sectional view taken along the line A-A of Figure 4a, and shows an expanded view of the boundary portion between the power MOSFET block 1 and the IC block 2. In Figure 4b, reference numeral 4 designates a back gate region layer (channel region) of an end portion of the power MOSFET block formed on a silicon substrate 33. A source region layer 5 is formed in the back gate region layer 4 and electrode wiring 7 (source electrode) is connected to the source region layer 5 and the back gate region layer 4. A temperature monitoring element 8 is covered by an insulating layer 9 and insulated from the other layers. The temperature monitoring element 8 is positioned in the IC block 2 adjoining to the power MOSFET block 1 so as to facilitate detecting the temperature of the power MOSFET block 1. The electrode wiring 7 does not extend over the temperature monitoring element 8. In Figure 4, the illustrated power MOSFET block 1 is formed as a vertical MOS, but the power MOSFET block 1 may be formed as a planar MOS. A drain electrode of the vertical MOS is formed on a back surface of the silicon substrate 33 and a drain electrode of the planar MOS is formed on the same side of the silicon substrate on that the planar MOS is formed. Usually, the power MOSFET block 1 is composed of many unit structures (cell structure) arranged in a row, each of which comprises a gate electrode 6 formed as a planar grid or a stripe and the back gate region layer 4 formed corresponding to the gate electrode as a polygonal island or a stripe.

In the power apparatus to which the power IC device described above is mounted, the power MOSFET carrying excessive electric power, for example when a short circuit fault occurs in a load of a main circuit, generates heat. The generated heat is conducted to the temperature monitoring element 8 through the silicon substrate 33 and the insulating layer 9. Then, temperature information detected by the temperature monitoring element 8 is fed to the protective circuit and the protective circuit switches off the power MOSFET to protect the power IC device 2 when the temperature exceeds a predetermined level.

However, the temperature monitoring element 8 senses temperature considerably less than the actual temperature of the power MOSFET block 1, due to the temperature gradient between the power MOSFET block 1 and the temperature monitoring element 8, since the temperature monitoring element 8 is positioned on a surface of the IC block that itself generates less heat. The considerably lower temperature sensed by the monitoring element 8 and corresponding to abnormal temperature of the power MOSFET block 1 is not detected immediately the abnormal temperature is caused by the malfunction affecting the power MOSFET block 1. A time lag that cannot be ignored exists from the malfunction until the temperature of the monitoring element 8 reaches the predetermined detection level because of thermal capacity based on the volume of the substrate between the power MOSFET block 1 and the monitoring element 8, and is further increased by the insulating layer 9 of low thermal conductivity. During the time lag, abnormal heat generation continues to cause circuit breakdown.

In Japan Patent Abstracts JP-A-1-047077, a substrate has a temperature monitoring element which is surrounded by the power element it monitors, and an insulating layer and electrode layer cover the power element. Temperature monitoring element has a polycrystal silicon resistance set onto the substrate, with leads connecting to the ends of the resistance. To provide access for the leads, the upper surface of the temperature monitoring element is uncovered.

In view of the foregoing, an object of the present invention is to provide a semiconductor device that solves the aforementioned problem of the prior art by provision of a temperature monitoring element that more exactly and quickly monitors the temperature of the power element block.

The object of the present invention is achieved by a semiconductor device that comprises a first element formed on a semiconductor substrate and driven by supplied electric power and which generates heat by the supplied electric power; and a temperature monitoring element formed on the semiconductor substrate for detecting temperature of the first element, in which the temperature monitoring element is surrounded by the first element in all but a minor part of its periphery.

According to the invention, there is provided a semiconductor device comprising:
a power element formed on a semiconductor substrate and adapted to be driven by supplied electric power; and
a temperature monitoring element formed on said semiconductor substrate for detecting the temperature of said power element that generates heat by said supplied electric power, characterised in that the source electrode of said power element extends over and covers an upper surface of said temperature monitoring element through an insulating layer.

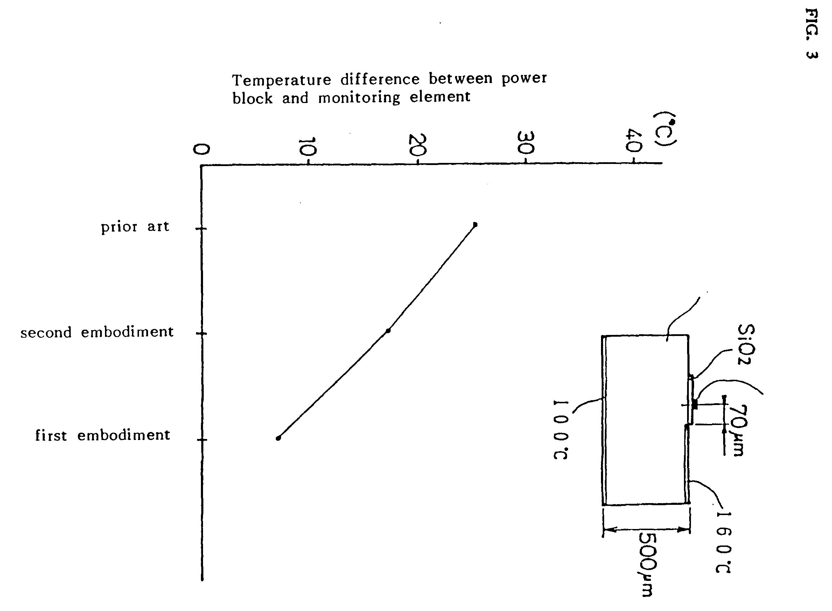

Figure 3 shows the temperature difference between a power block and a temperature monitoring element obtained from a mathematically simulated temperature distribution, investigated by the present inventor, of each block of a semiconductor device with a temperature monitoring element whose configuration and peripheral structure is designed according to the prior art. Figure 3 assumes a case in which heat is generated from a surface layer of the semiconductor substrate corresponding to the source region on the end portion of the power MOSFET. As shown in Figure 3, the temperature monitored by the temperature monitoring element is more than 25°C lower than that of the power block when the heat generative portion is at 160°C and the back surface is at 100°C. Temperature difference is estimated to be around 100°C by considering the temperature ratio described above since the temperature of the heat generative portion will rise by several hundred degrees when an accident like a short circuit fault of the load occurs. Therefore, it is necessary for preventing thermal breakdown of the power MOSFET to detect temperature as near as possible to the temperature of the power block by reducing any difference between the actual and detected temperatures.

According to the present invention, heat from the heat generative portion is conducted to the temperature monitoring element through the source electrode of high thermal conductivity as well as through the semiconductor substrate to supply sufficient heat to quickly raise the temperature of the monitoring element to the detection level.

Thus temperature difference between the heat generative portion and the temperature monitoring element is reduced and the temperature of the monitoring element quickly rises to facilitate quick and accurate monitoring of the temperature of the heat generative portion.

In one embodiment of the present invention, the temperature monitoring element is so formed that the monitoring element is surrounded on three of its sides by the power element driven by the supplied electric power. Therefore, more heat is transferred multi-directionally in comparison with uni-directional heat transfer to supply sufficient heat to quickly raise the temperature of the monitoring element to the detection level.

By surrounding the temperature monitoring element with the element driven by supplied electric power and by covering the monitoring element with an electrically conductive layer integrated with the electrode of the power element, sufficient heat is supplied more quickly to raise the temperature of the monitoring element to the detection level.

The present invention will now be described in detail with reference to the accompanying drawings, which illustrate various embodiments of the present invention.
Figure 1 is a diagram for explaining the configuration and the peripheral structure of a temperature monitoring element in the power IC device of the first embodiment according to the present invention;
Figure 2 is a diagram for explaining the configuration and the peripheral structure of a temperature monitoring element in the power IC device of the second embodiment according to the present invention;
Figure 3 is a chart comparing temperature detection by the embodiments of the present invention with that by the prior art; and
Figure 4 is a diagram of the semiconductor device according to the prior art.

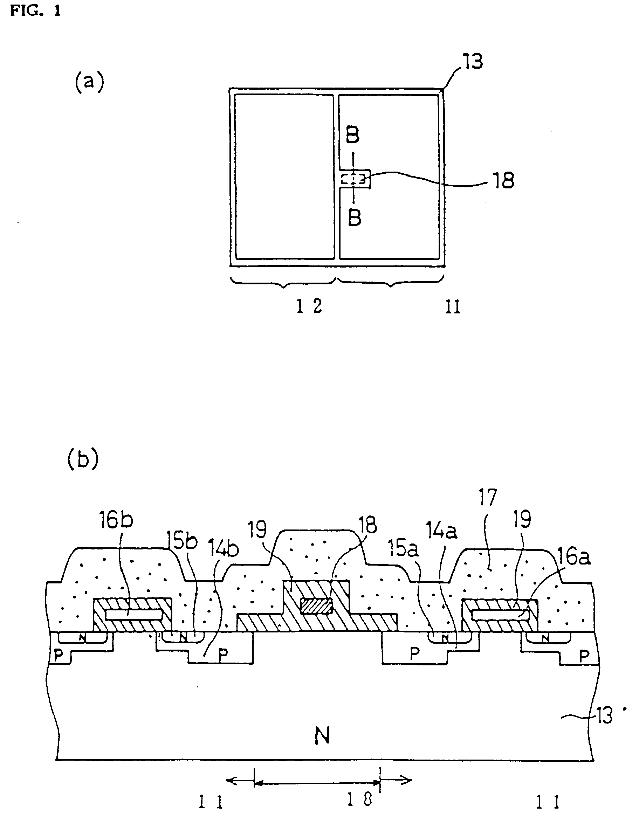

Referring to Figures 1 and 1b, the configuration and peripheral structure of a temperature monitoring element in the power IC device of a first embodiment of the present invention is seen.

Figure 1a is a top plan view showing an entire planar chip configuration of the power IC device. In Figure 1a, a temperature monitoring element 18 is arranged on a boundary portion between a power MOSFET block 11 to which electrical power is supplied and an IC block (control circuit block) 12. The monitoring element 18 is surrounded on three sides by the elements of the power MOSFET block 11, but its remaining side faces the IC block 12. No element of the power MOSFET block 11 is formed on the side facing to the IC block 12. since wiring to a protective circuit is provided on this side.

Figure 1b is a sectional view taken along line B-B of Figure la, and shows an expanded view of the boundary portion between the power MOSFET block 11 and the IC block 12.

In Figure 1b, reference numerals 14a and 14b designate back gate region layers of the power MOSFET formed in the surface of a silicon substrate 13 so as to surround the temperature monitoring element 18. Source region layers 15a and 15b are formed in the back gate region layers 14a and 14b. The back gate region layers 14a, 14b between the source region layers 15a, 15b and extending under gate electrodes 16a, 16b and the silicon substrate 13 form channel layers. Reference numeral 17 designates a source electrode, made for example of aluminium, connecting the back gate region layers 14a, 14b and the source region layers 15a, 15b. A temperature monitoring element 18, that utilises for example a reverse leakage current through a pn junction, detects the temperature of the heat generative power MOSFET to which electric power is supplied. The temperature monitoring element 18 is covered with an insulating layer 19, made for example of silicon oxide, and is insulated from the other elements.

In Figure 1b, the source electrode 17 extends over the temperature monitoring element 18 and is separated from the monitoring element 18 by the insulating layer 19.

In the power IC device described above, the channel layers are formed by applying negative voltage between the gate electrodes 16a and 16b, and a normal current flows through a path connecting between the source electrode 17, source region layers 15a, 15b, the channel layers and the silicon substrate 13. In this normal case. heat is generated mainly from the channel layers.

On the other hand, when an accident happens, an abnormal current may flow through a path connecting between the source region layers 15a, 15b. back gate region layers 14a, 14b and the silicon substrate 13. In this abnormal case, abnormal heat may be generated mainly either from the pn junctions between the source region layers 15a. 15b and the back gate region layers 14a. 14b or from the pn junctions between the back gate region layers 14a, 14b and the silicon substrate 13. The abnormal heat is conducted towards three sides of the temperature monitoring element 18 through the silicon substrate 13 and the source electrode 17, and is detected by the monitoring element 18.

Then the temperature information from the temperature monitoring element 18 is sent to the protective circuit of the IC block 12, and the protective circuit stops operation of the power MOSFET, for example by disconnecting a power supply from the power MOSFET.

To confirm temperature detection accuracy of the configuration described above, mathematical simulation was conducted on a model that has a similar configuration and peripheral structure to those of the temperature monitoring element 18 of the first embodiment. The temperature difference between the heat generative portion and the temperature monitoring element obtained from the simulated temperature distribution of each block is shown in Figure 3, in which heat is generated from a surface layer of the silicon substrate 70 µm apart from the monitoring element 18. The thickness of the silicon substrate was set at 500 µm. As shown in Figure 3, the temperature difference between the heat generative portion and the monitoring element is less than 10°C, that is greatly reduced from 25°C of the prior art, when the heat generative portion is at 160°C and the back surface is at 100°C.

As described above, the temperature monitoring element is surrounded on three sides by the heat generative portion of the power MOSFET in the power IC device of the first embodiment according to the present invention. Therefore, more heat is transferred across the three sides to the temperature monitoring element in comparison with uni-directional heat transfer to supply sufficient heat.

In addition to this, the source electrode 17 extends over the insulating layer 19. Since the source electrode 17 is highly thermally conductive. heat from a heat generative portion is conducted to the temperature monitoring element through the source electrode 17 as well as the silicon substrate 13.

Therefore, the heat necessary for the temperature detection is supplied to the temperature monitoring element so as to quickly and accurately raise its temperature as the temperature of the power MOSFET block 11 increases.

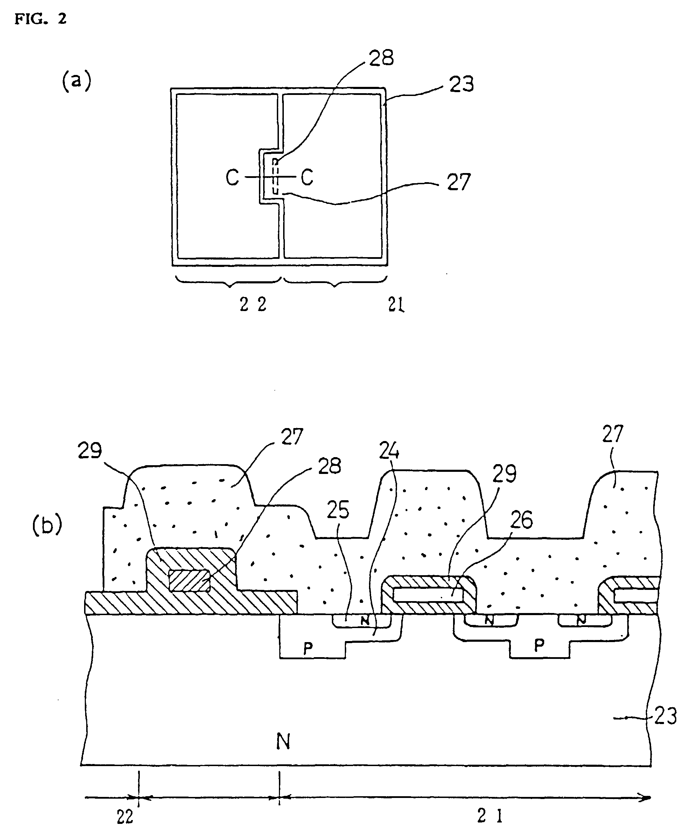

Figures 2a and 2b show a configuration and peripheral structure of a temperature monitoring element in the power IC device of a second embodiment of the present invention.

Figure 2a is a top plan view showing an entire planar chip configuration of the power IC device. In Figure 2a, a temperature monitoring element 28 is arranged on a boundary portion between a power MOSFET block 21 and an IC block 22.

Figure 2b is a sectional view taken along line C-C of Figure 2a that shows an expanded view of the boundary portion between the power MOSFET block 21 and the IC block 22.

In Figure 2b, the power MOSFET is arranged in close proximity to the temperature monitoring element 28 on one side of the monitoring element as in the prior art. However, the power IC device of the second embodiment is different from the power IC device of the prior art in that a source electrode 27 of the power MOSFET extends over the temperature monitoring element 28 and is separated from the monitoring element 28 by the insulating layer 29.

In Figure 2b, reference numeral 24 designates a back gate region layer of the power MOSFET formed on a silicon substrate 23 in close proximity to the temperature monitoring element 28. A source region layer 25 is formed in the back gate region layer 24. A channel layer is formed by that part of the back gate region layer 24 situated between the source region layer 25 and the silicon substrate 23 and lying under a gate electrode 26. Reference numeral 27 designates a source electrode connecting between the back gate region layer 24 and the source region layer 25. The temperature monitoring element 28 is covered with the insulating layer 29 and electrically insulated from the other elements thereby. The source electrode 27 extends over the temperature monitoring element 28. but is separated therefrom by the insulating layer 29.

When an accident happens in the power IC device described above, an abnormal current may flow through a path extending between the source region layer 25, back gate region layer 24 and the silicon substrate 23. In this abnormal case, abnormal heat may be generated mainly either from the pn junctions between the source region layer 25 and the back gate region layer 24 or from the pn junction between the back gate region layer 24 and the silicon substrate 23. The abnormal heat is conducted to the temperature monitoring element 28 through the silicon substrate 23 and through the source electrode 27, and is detected by the monitoring element 28. Then the temperature information from the temperature monitoring element 28 is sent to the protective circuit of the IC block 22, and the protective circuit stops operation of the power MOSFET, for example by disconnecting a power supply from the power MOSFET.

To confirm temperature detection accuracy of the second embodiment described above, mathematical simulation was conducted on a model that has a similar configuration and peripheral structure to those of the temperature monitoring element 28 of the second embodiment. Temperature difference between the heat generative portion and the temperature monitoring element obtained from the simulated temperature distribution of each block is shown in Figure 3, in which heat is generated from a surface layer of the silicon substrate 70 µm apart from the monitoring element 28. The thickness of the silicon substrate was set at 500 µm. As shown in Figure 3, the temperature difference between the heat generative portion and the monitoring element is less than 17°C, that is considerably reduced from 25°C of the prior art, when the heat generative portion is 160°C and the back surface is 100°C.

Thus, the temperature monitoring element 28 monitors the temperature of the power MOSFET block 21 more accurately than the prior art. The protective circuit prevents the MOSFET and its control circuit from breakdown based on the temperature information fed from the monitoring element.

Though the embodiments of the present invention are described on the vertical MOSFET, the present invention is applicable to a power IC that incorporates a planar MOSFET or a thyristor.

As has been described so far, according to the present invention, the source electrode of the power element extends over and covers the temperature monitoring element. Therefore, heat from the heat generative portion is conducted towards the temperature monitoring element through the electrically conductive layer of high thermal conductivity as well as through the semiconductor substrate to supply sufficient heat for detection. Thus temperature difference between the heat generative portion and the temperature monitoring element is reduced and the temperature of the monitoring element quickly rises to facilitate the rapid and accurate monitoring the temperature of the heat generative portion.

In addition, the temperature monitoring element is so formed that the monitoring element is surrounded by the power element driven by the supplied electric power in the present invention. Therefore, more heat is transferred multi-directionally towards the temperature monitoring element in comparison with uni-directional heat transfer of the prior art, in order to supply sufficient heat quickly to raise the temperature of the monitoring element to the detection level.

## Claims

1. A semiconductor device comprising:
a power element (11) formed on a semiconductor substrate (13) and adapted to be driven by supplied electric power; and
a temperature monitoring element (18) formed on said semiconductor substrate (13) for detecting the temperature of said power element that generates heat by said supplied electric power,
characterised in that the source electrode (17) of said power element (11) extends over and covers an upper surface of said temperature monitoring element (18) through an insulating layer.

2. A semiconductor device according to Claim 1, characterised in that said temperature monitoring element (18) is surrounded on three of its sides by said power element (11).

3. A semiconductor device according to Claim 1 or Claim 2, characterised in that an IC element (12) is provided on the semiconductor substrate (13) for controlling the power element (11).

## Patentansprüche

1. Halbleiterbauelement, umfassend: ein Leistungselement (11) auf einem Halbleitersubstrat (13), welches mit elektrischem Strom betreibbar ist; und ein Temperaturüberwachungselement (18) auf dem Halbleitersubstrat (13) zur Detektion der Temperatur des Leistungselements, welches durch den zugeführten elektrischen Strom Wärme erzeugt, **dadurch gekennzeichnet**, daß die Source-Elektrode (17) des Leistungselements (11) sich über eine obere Oberfläche des Temperaturüberwachungselements (18) durch eine Isolierschicht erstreckt und diese bedeckt.

2. Halbleitervorrichtung nach Anspruch 1, **dadurch gekennzeichnet**, daß das Temperaturüberwachungselement (18) an drei seiner Seiten von dem Leistungselement (11) umgeben ist.

3. Halbleitervorrichtung nach einem der Ansprüche 1 oder 2, **dadurch gekennzeichnet**, daß ein IC-Element (12) auf dem Halbleitersubstrat (13) zur Steuerung des Leistungselements (11) vorgesehen ist.

## Revendications

1. Dispositif à semi-conducteur, comprenant:
un composant de puissance (11) formé sur un substrat (13) en semi-conducteur et conçu pour être excité par un courant électrique fourni; et
un élément (18) de contrôle de température formé sur ledit substrat (13) en semi-conducteur pour détecter la température dudit composant de puissance qui produit de la chaleur du fait du courant électrique fourni, caractérisé en ce que l'électrode de source (17) dudit composant de puissance (11) s'étend sur et recouvre la surface supérieure dudit élément (18) de contrôle de température, via une couche isolante.

2. Dispositif à semi-conducteur selon la revendication 1, caractérisé en ce que ledit élément (18) de contrôle de température est entouré sur trois de ses côtés par ledit composant de puissance (11).

3. Dispositif à semi-conducteur selon la revendication 1 ou la revendication 2, caractérisé en ce qu'un élément (12) à circuits intégrés est disposé sur le substrat (13) en semi-conducteur pour commander le composant de puissance (11).
